# EUROPEAN PATENT SPECIFICATION

(11) **EP 1 617 338 B1**
(45) Date of publication and mention of the grant of the patent: **23.12.2009**
(21) Application number: 04253467.7
(22) Date of filing: 10.06.2004
(51) Int. Cl.: G06F 15/00

(54) **System and method for run-time reconfiguration**
System und Verfahren für Laufzeit-Rekonfiguration
Système et procede pour reconfiguration en temps d'execution

(43) Date of publication of application: 18.01.2006
(73) Proprietor: Panasonic Corporation, Kadoma-shi Osaka 571-8501 (JP)
(72) Inventor: Al Adnani, Adnan Panasonic Broadband Communication, Wokingham Berkshire RG40 2AQ (GB)
(74) Representative: Haley, Stephen

(56) References cited:
- EP-A- 0 370 473
- US-A- 4 918 637
- DENK T C ET AL: "Reconfigurable hardware for efficient implementation of programmable FIR filters" ACOUSTICS, SPEECH AND SIGNAL PROCESSING, 1998. PROCEEDINGS OF THE 1998 IEEE INTERNATIONAL CONFERENCE ON SEATTLE, WA, USA 12-15 MAY 1998, NEW YORK, NY, USA,IEEE, US, 12 May 1998 (1998-05-12), pages 3005-3008, XP010279408 ISBN: 0-7803-4428-6

## Description

The present invention relates to a system and method for run-time reconfiguration of digital signal processing (DSP) systems.

The basic concept of reconfigurable processing has been in existence for quite some time. For example, even general purpose processors use some of the same basic ideas, such as reusing computational components for independent computations and using multiplexers to control the routing between these components. However, the term "reconfigurable processing" as it is used in current research refers to systems incorporating some form of hardware programmability, customizing how the hardware is used utilising a number of physical control points. These control points can then be changed periodically in order to execute different applications using the same hardware.

The use of reconfigurable architectures is gaining an important role in system-on-a-chip design platforms. Applying reconfigurable architecture to implement not only dataflow intensive computations but also control oriented computation or data stream based computation (e.g. data routing, shuffling and interleaving) is a promising approach. However, most of the work to date has focused on software radio base stations, which do not have the power and size constraints of mobile terminals. There is still a need for development of systems wherein Software Defined Radio (SDR) technologies can be supported on a mobile terminal.

Run-time reconfiguration may be defined as online reconfiguration of a real-time signal processing system without the need for deactivating the system during the reconfiguration process. In order to achieve this, a degree of flexibility is required in the architecture to allow parts of the system to be reconfigured while other parts continue operating.

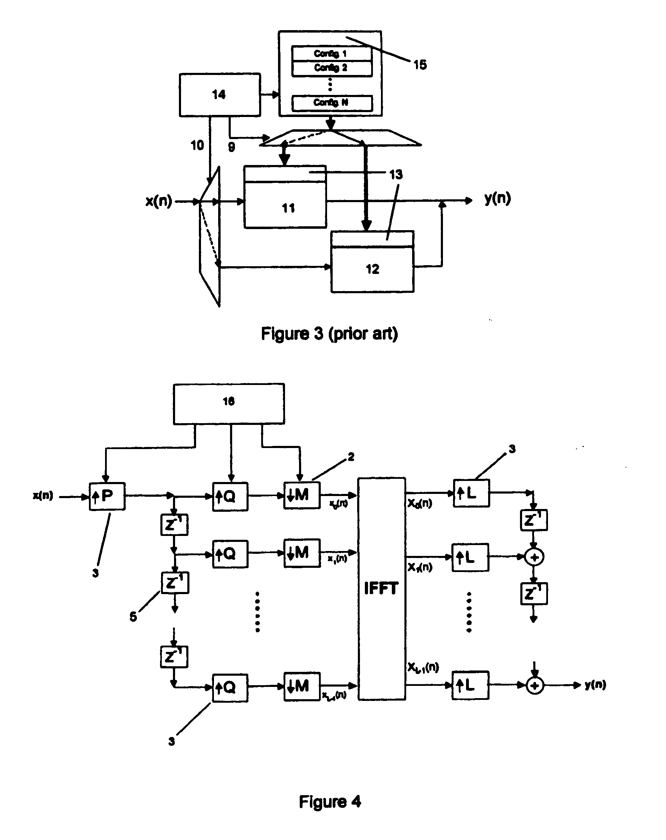

Prior art systems which use run-time reconfiguration consist basically of two processing blocks 11, 12 which perform the signal processing operations (see figure 3). These processing blocks 11, 12 can be fine grain (bit level) blocks, coarse grain blocks or a chain of blocks performing successive algorithms as in a communication system physical layer. Such systems also have a configuration controller 14 that selects the required configuration stored in a configuration memory 15 and also controls multiplexers or switches 9, 10 which determine which processing block processes the signal and which processing block is configured by loading a new configuration into the processing block memory 13.

In such a prior art system, only one of the processing blocks is active during normal operations, while the other processing block is configured with the new configuration representing a software update/upgrade or a different mode of operation, for example, to suit another communication system standard.

This redundancy in the processing blocks during normal operation is not the most effective use of resources. For example, the processing rate is higher than necessary and therefore power consumption is higher than necessary. Accordingly, there is a need for a run-time reconfiguration system with a minimum amount of redundancy in the system and reduced power consumption.

US4918637A discloses a multichannel decimation/ interpolation filter.

According to the present invention there is provided a reconfigurable digital signal processing system comprising:
a serial to parallel converter comprising at least one delay block and at least one decimation block arranged to convert a first serial signal with a first sampling rate to a multiplicity of parallel subband signals with a second sampling rate, wherein the second sampling rate is less than or equal to the first sampling rate;
processing blocks arranged to process the subband signals to produce processed signals;
a configuration controller arranged to modify the decimation factor of each decimation block and to load a configuration into the memory of a processing block;
a parallel to serial converter comprising at least one expansion block, the parallel to serial converter arranged to recover from the processed signals a second serial signal with a sampling rate substantially equal to the first sampling rate;
wherein in normal run-time operation the decimation factor of each decimation block is equal to the number of subband signals and when run-time reconfiguration is required the configuration controller is arranged to decrease the decimation factor so that the second sampling rate increases; load the configuration into the memory of a processing block; and increase the decimation factor to again be equal to the number of subband signals.

According to the present invention there is also provided a method of processing a digital signal in a reconfigurable digital processing system, the method comprising the steps of:
serial to parallel converting a first serial signal with a first sampling rate to a multiplicity of parallel subband signals with a second sampling rate, by means of a serial to parallel converter comprising at least one delay block and at least one decimation block, wherein the second sampling rate is less than or equal to the first sampling rate;
processing the subband signals to produce processed signals, by means of processing blocks;
parallel to serial converting the processed signals to recover a second serial signal with a sampling rate substantially equal to the first sampling rate from the processed signals;
wherein in normal run-time operation the decimation factor of each decimation block is equal to the number of subband signals and when run-time reconfiguration is required the method further comprises the steps of:
decreasing the decimation factor of the decimation block so that the second sampling rate increases, by means of a configuration controller;
loading a configuration into the memory of a processing block by means of the configuration controller;
increasing the decimation factor to again be equal to the number of subband signals, by means of the configuration controller.

Examples of the present invention will now be described with reference to the accompanying drawings, in which:
Figure 1 shows a reconfigurable system according to an example of the present invention;
Figure 2 is a diagram of an example M-fold decimator and an example M-fold expander for M = 3, the principles of which are used in the present invention;
Figure 3 shows a general prior art reconfigurable system;
Figure 4 shows a reconfigurable OFDM transmitter according to an example of the present invention;
Figure 5 shows a basic prior art OFDM transceiver; and
Figure 6 is a diagram illustrating the concept of a cyclic prefix in an OFDM transceiver;

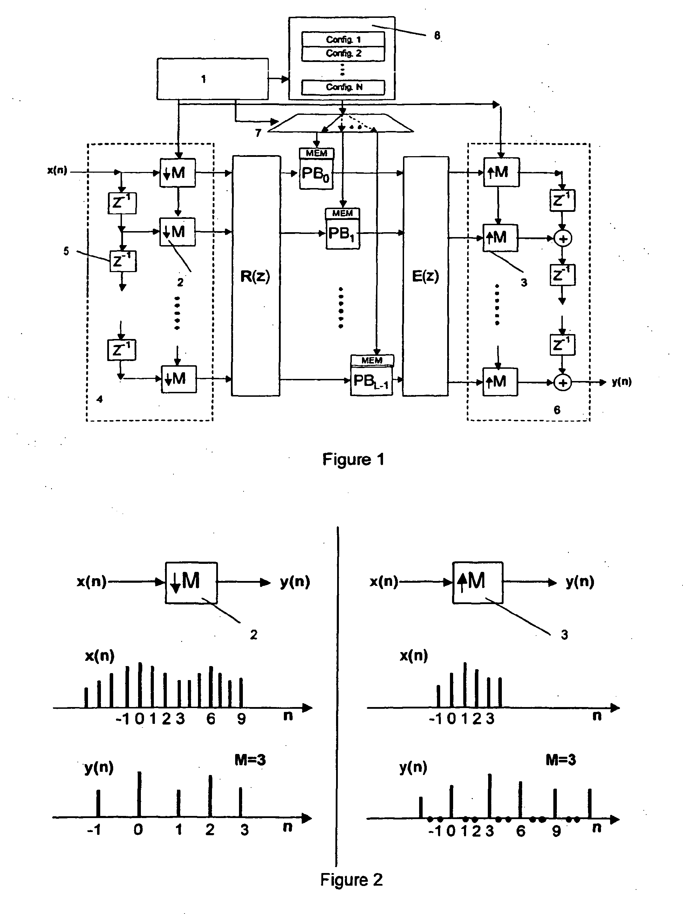

Figure 1 shows an example of the present invention, which is a sub band-reconfigurable system combining a multirate processing system with a configuration controller 1, a switch 7 and a configuration memory 8. The multirate processing system comprises a serial to parallel converter, processing blocks PB and a parallel to serial converter 6. A multirate system is a system where the sampling rate differs at various parts of the system by employing digital sample rate converters known as decimators 2 (subsamplers) and expanders 3 (upsamplers). An M-fold decimator 2 retains only every Mth sample, and an M-fold expander 3 inserts M-1 zeros between adjacent samples. Figure 2 shows an example for M=3.

As shown in Figure 1, a digital signal x(n) with sampling rate S samples/second is firstly serial-to-parallel converted using a serial to parallel converter 4 comprising a chain of delay blocks 5 combined with M-fold decimation blocks 2 to produce L parallel signals Xₖ(n), where M ≤ L, and M & L are positive integers. The subband signals xₖ(n) are also known as the polyphase representation of x(n) . This process is de-interleaving the signal x(n) into parallel subbands. This has the effect of reducing the sampling rate by S/M samples/second.

The R(z) block in figure 1 is a real or complex forward transform ensuring that the subband xₖ(n) signals are orthogonal and the original signal can be reconstructed without aliasing due to decimation. The subband signals xₖ(n) are then processed by processing blocks (PBₖ) . PBₖ may be identical or different algorithms depending on the application. The advantage of using multiple Processing Blocks in parallel is that all the processing is carried out in parallel at a sampling rate of S/M.

The inverse transform E(z) block reconstructs the subbands before the parallel to serial converter recovers the signal y(n) at the original sampling rate S. R(z) and E(z) are constrained such that R(z)E(z) = I , where I is the identity matrix. A special case is when R(z) is the Inverse Fast Fourier Transform(IFFT) and E(z) is the Fast Fourier Transform (FFT).

In normal run-time operation the decimation rate M is equal to the number of sub bands L where the processing blocks are operating at a sampling rate of S/L samples per second. The processing bocks could be any DSP algorithms for example a channel coder or a compression scheme. L is usually chosen to be a power of 2 to achieve fast implementation of the transform R(z) and E(z). As the digital signal processing is carried out at a rate of S/L samples per second which is a fraction of the original signal sampling rate of S samples per second, the complexity and power of the system is greatly reduced compared to that of a system processing at a rate of S samples per second.

When M=L this is called a maximally decimated filter bank where no redundancy in the sample rate conversion is imposed and the lowest processing rate is achieved. However when M< L a degree of redundancy can be imposed such that the last L-M sub bands Xₖ (n) and the first L-M sub bands are identical except for a delay. For example if L= 4 and M=3 the sub-band signals X₀(n) and X₃(n) are identical. This gives the required redundancy to reconfigure the Processing Blocks at run-time without requiring extra resources. This redundancy in the sub-bands is at the cost of processing rate, but nothing like as much as the 2:1 redundancy of the prior art and with reduced power consumption too.

At reconfiguration time the configuration controller 1 modifies the decimation and expansion factor M to impose some redundancy in the subbands and allow the configuration controller 1 to load a new configuration into the memory of the redundant processing blocks during run-time.

The processing blocks may be implemented on CPUs or DSP systems in which case loading a new configuration into the memory of the processing blocks may be loading a new program into the program memory. The program is then instantiated and executed.

The processing blocks may be programmable logic blocks such as field programmable gate arrays, in which case loading a configuration into the memory of the processing blocks may be loading a new configuration bit stream into the configuration memory including, for example, routing tables. The configuration is then executed.

The transform block R(z) and inverse transform block E(z) may also be reconfigured if required.

Different reconfiguration strategies are possible depending on the number of channels used L, and the values of M chosen by the controller.

In the simplest case L is equal to 2, and M can only have the values 1 and 2. In this case the system operates normally with two Processing Blocks PB₀ and PB₁, and M=L=2. At reconfiguration time M is changed to 1 by the controller. This means that no decimation occurs and the sub-band signals are equivalent and being processed at the sampling rate of x(n). In this case R(z) and E(z) can be bypassed when M=1 since the signals are the same. Then configuration controller 1 deactivates PB₁, loads a new configuration for PB₁ while PB₀ continues normal operation at this time with the old configuration. When PB₁ is configured with its new configuration it is activated while the controller switches to PB₀ to perform the same operation while PB₁ is operating now with the new configuration. When PB₀ is finished with its configuration, the controller sets M back to 2, thus returning back to the normal mode of operation with new configurations for PB₀ and PB₁ and with a lower sampling rate.

The trade off is that at reconfiguration time the Processing Blocks are operating at the higher sampling rate of x (n). The power consumption is inversely proportional to the number of sub-bands, which means that the larger L is the less power consumption even during reconfiguration. For an even number of channels L, M can be reduced incrementally at reconfiguration time or once to a value of L/2. This means that a redundancy of 2 channels simultaneously is achieved when M is equal to L/2.

For example if L is 4, M can be modified such that the controller first changes M to 3, this results in the first and last subband (or channel) being identical which allows reconfiguration of PB₀ and PB₃ first then changing M to 2 result in the second and third channel and first and last channel being identical, this allows reconfiguration of PB₁ and PB₂. Another possibility is that at reconfiguration time M is changed at once to 2. This results in the first channel and the third channel being the same, and the second and fourth channel being the same. This allows PB₀ and PB₁ to be reconfigured together since PB₂ and PB₃ are processing the same signals. Then PB₂ and PB₃ be reconfigured together before setting M back to 4 to continue with normal operation. The difference here is that more than one block can be reconfigured at the same time.

For an odd number of channels L, M will need to be decremented down to a value of (L+1)/2 for sequential reconfiguration or at once for parallel reconfiguration of the processing blocks. For practical reasons L should be restricted to even values.

Another advantage of this system is it gives an opportunity to test the new block(s) for errors before the system is fully reconfigured. If an error is detected during configuration or activation of the new block, error recovery or roll back can be performed without affecting the rest of the system.

Figure 4 shows an Orthogonal Frequency Division Multiplex (OFDM) system according to an example of the present invention. An OFDM system is a specific application that uses the multirate techniques of the previous example. AS shown in figure 4, the OFDM system has a configuration controller 16, decimators 2 and expanders 3.

Multi-carrier communication systems like OFDM systems have an inherent advantage over single carrier systems in frequency-selective fading channels. OFDM systems have been adopted by various standards in recent years including xDSL and 802.lla wireless LAN standards.

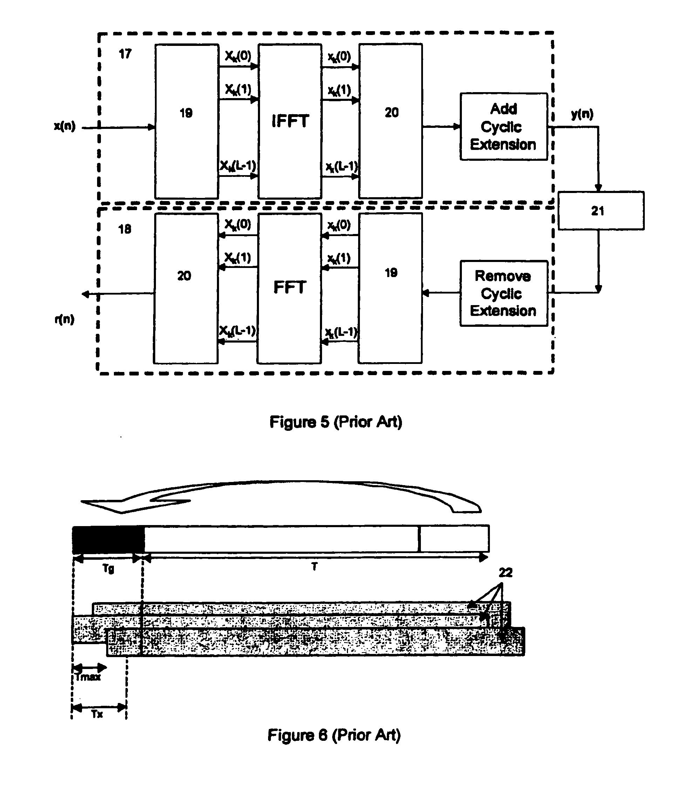

Figure 5 shows a basic prior art OFDM system with a channel 21 and a transmitter 17 and receiver 18 each comprising a serial to parallel converter 19 and a parallel to serial converter 20. Data is carried on narrow-band sub-carriers in the frequency domain. Data is transformed into the time-domain using an IFFT at the transmitter and transformed back to the frequency-domain using a FFT at the receiver. The total number of sub-carriers translates into the number of points of the IFFT/FFT.

Data to be transmitted is typically in the form of a serial data stream. In OFDM, each symbol typically transmits 40 - 4000 bits, and so a serial to parallel conversion stage is needed to convert the input serial bit stream to the data to be transmitted in each OFDM symbol. The data allocated to each symbol depends on the modulation scheme used and the number of sub-carriers. For example, for a sub-carrier modulation of 16-QAM each sub-carrier carries 4 bits of data, and so for a transmission using 100 sub-carriers the number of bits per symbol would be 400. Most of the sub-carriers are modulated with data. The outer sub-carriers are un-modulated and set to zero amplitude. These zero sub-carriers provide a frequency guard band before the Nyquist frequency and effectively act as an interpolation of the signal and allows for a realistic roll off in the analog anti-aliasing reconstruction filters.

Cyclic prefix is a crucial feature of OFDM used to combat the Inter Symbol Interference (ISI) and Inter Channel Interference (ICI) introduced by the multi-path channel through which the signal is propagated. The basic idea is to replicate part of the OFDM time-domain waveform from the back to the front to create a guard period. The duration of the guard period Tg should be longer than the worst-case delay spread of the target multi-path environment.

Figure 6 illustrates the idea, with multipath components 22. At the receiver, a certain position within the cyclic prefix is chosen as the sampling starting point, which satisfies the criteria Tmax < Tx < Tg, where Tmax is the worst-case multi-path spread. Once the above condition is satisfied, there is no ISI since the previous symbol will only have effect over samples within [0, Tmax]. It is also clear from the figure that a sampling period starting from Tx will encompass the contribution from all the multi-path components so that all the samples experience the same channel and there is no ICI.

The multirate principles introduced previously add flexibility and reconfigurabilty to the OFDM system such that guard periods and cyclic prefix can be easily varied either according to channel conditions or to be reconfigured to other standards that use OFDM including possible future 4G standards.

In an example OFDM system according to the present invention as shown in figure 4, expanders 3, P and Q, are introduced to the system and the decimators 2 have a variable value M < L. The decimators 2 have the effect of adding a cyclic prefix of length L-M by replicating the last L-M sub-bands into the first L-M sub-bands, which has the effect of adding a cyclic extension of length L-M.

The expander 3 with the variable value Q inserts Q-1 zeros forcing all sub-carriers to zero, thus allowing the insertion of pilot signals at the required carriers according to the standard's requirements. Pilot signals are signals known to the receiver used for determining the quality of the received signal and for channel modelling.

The expander 3 with the variable value P inserts P-1 zeros between each data sample x(n) which has the effect of forcing zero carriers in between data carriers thus introducing a guard band of length P-1 that can reduce the effect of ICI.

## Claims

1. A reconfigurable digital signal processing system comprising:
a serial to parallel converter (4) comprising at least one delay block (5) and at least one decimation block (2) arranged to convert a first serial signal (x(n)) with a first sampling rate to a multiplicity (L) of parallel subband signals with a second sampling rate, wherein the second sampling rate is less than or equal to the first sampling rate;
processing blocks (PB0₀,PB₁,PB_{L-1}) arranged to process the subband signals to produce processed signals;
a configuration controller (1) arranged to modify the decimation factor (M) of each decimation block and to load a configuration into the memory (MEM) of a processing block;
a parallel to serial converter (6) comprising at least one expansion block (3), the parallel to serial converter arranged to recover from the processed signals a second serial signal (y(n)) with a sampling rate substantially equal to the first sampling rate;
wherein in normal run-time operation the decimation factor (M) of each decimation block (2) is equal to the number (L) of subband signals and when run-time reconfiguration is required the configuration controller is arranged to decrease the decimation factor so that the second sampling rate increases; load the configuration into the memory of a processing block; and increase the decimation factor to again be equal to the number of subband signals.

2. A reconfigurable digital signal processing system according to claim 1, wherein the configuration controller (1) is arranged to perform successive decreases in the decimation factor (M) to incrementally load a configuration.

3. A reconfigurable digital signal processing system according to claim 1 or claim 2, further comprising:
a transform means (R(z)) arranged to transform the subband signals before the subband signals are processed by the processing blocks (PB₀, PB₁, PB_{L-1}); and
an inverse transform means (E(z)) arranged to inverse transform the processed signals before the processed signals are parallel to serial converted by the parallel to serial converter (6).

4. A reconfigurable digital signal processing system according to claim 3, wherein the transform means (R(z)) is a fast fourier transform means and the inverse transform means (E(z)) is an inverse fast fourier transform means.

5. A method of processing a digital signal in a reconfigurable digital processing system, the method comprising the steps of:
serial to parallel converting a first serial signal (x(n)) with a first sampling rate to a multiplicity (L) of parallel subband signals with a second sampling rate, by means of a serial to parallel converter (4) comprising at least one delay block (5) and at least one decimation block (2), wherein the second sampling rate is less than or equal to the first sampling rate;
processing the subband signals to produce processed signals, by means of processing blocks (PB₀, PB₁, PB_{L-1}) ;
parallel to serial converting the processed signals to recover a second serial signal (y(n)) with a sampling rate substantially equal to the first sampling rate from the processed signals;
wherein in normal run-time operation the decimation factor (M) of each decimation block is equal to the number (L) of subband signals and when run-time reconfiguration is required the method further comprises the steps of:
decreasing the decimation factor of the decimation block so that the second sampling rate increases, by means of a configuration controller (1);
loading a configuration into the memory (MEM) of a processing block by means of the configuration controller;
increasing the decimation factor to again be equal to the number of subband signals, by means of the configuration controller.

6. A method of processing a digital signal in a reconfigurable digital processing system according to claim 5, wherein the configuration controller (1) performs successive decimation factor decreasing steps and incrementally loads a configuration.

7. A method of processing a digital signal in a reconfigurable digital processing system according to claim 5 or claim 6, further comprising the steps of:
transforming (R(z)) the subband signals before the processing step; and
inverse transforming (E(z)) the processed signals before the parallel to serial converting step.

8. A method of processing a digital signal in a digital signal processing system according to claim 7, wherein the transforming step (R(z)) is a fast fourier transforming step and the inverse transforming step (E(z)) is an inverse fast fourier transforming step.

## Patentansprüche

1. Rekonfigurierbares Digitalsignalverarbeitungssystem mit:
einem Seriell-zu-Parallel-Konverter (4) mit wenigstens einem Verzögerungsblock (5) und wenigstens einem Dezimierungsblock (2), der ausgestaltet ist, ein erstes serielles Signal (x(n)) mit einer ersten Abtastrate in eine Vielzahl (L) von parallelen Subband-Signalen mit einer zweiten Abtastrate zu konvertieren, wobei die zweite Abtastrate geringer als oder gleich der ersten Abtastrate ist,
Verarbeitungsblöcken (PB₀, PB₁, PB_{L-1}), die ausgestaltet sind, die Subband-Signale zu verarbeiten, um verarbeitete Signale zu erzeugen,
einer Konfigurationssteuereinheit (1), die ausgestaltet ist, den Dezimierungsfaktor (M) eines jeden Dezimierungsblocks zu modifizieren und eine Konfiguration in den Speicher (MEM) eines Verarbeitungsblocks zu laden,
einen Parallel-zu-Seriell-Konverter (6) mit wenigstens einem Expansionsblock (3), wobei der Parallel-zu-Seriell-Konverter ausgestaltet ist, ein zweites serielles Signal (y(n)) mit einer Abtastrate, die im Wesentlichen gleich zu der ersten Abtastrate ist, aus den verarbeiteten Signalen zurückzugewinnen,
wobei bei normalem Laufzeit-Betrieb der Dezimierungsfaktor (M) eines jeden Dezimierungsblocks (2) gleich der Anzahl (L) von Subband-Signalen ist und wobei, wenn eine Laufzeit-Rekonfiguration nötig ist, die Konfigurationssteuereinheit dazu ausgestaltet ist, den Dezimierungsfaktor zu verringern, so dass sich die zweite Abtastrate erhöht, die Konfiguration in den Speicher eines Verarbeitungsblocks zu laden und den Dezimierungsfaktor zu erhöhen, so dass er erneut gleich der Anzahl von Subband-Signalen ist.

2. Rekonfigurierbares Digitalsignalverarbeitungssystem nach Anspruch 1, wobei die Konfigurationssteuereinheit (1) ausgestaltet ist, sukzessive Verringerungen an dem Dezimierungsfaktor (N) vorzunehmen, um eine Konfiguration inkrementell zu laden.

3. Rekonfigurierbares Digitalsignalverarbeitungssystem nach Anspruch 1 oder 2, ferner mit:
einem Transformierungsmittel (R(z)), das ausgestaltet ist, die Subband-Signale zu transformieren, bevor die Subband-Signale von den Verarbeitungsblöcken (PB₀, PB₁, PB_{L-1}) verarbeitet werden, und
einem Invers-Transformierungsmittel (E(z)), das ausgestaltet ist, die verarbeiteten Signale invers zu transformieren, bevor die verarbeiteten Signale durch den Parallel-zu-Seriell-Konverter (6) parallel-zu-seriell-konvertiert werden.

4. Rekonfigurierbares Digitalsignalverarbeitungssytem nach Anspruch 3, wobei das Transformierungsmittel (R(z)) ein Schnelle-Fourier-Transformierungsmittel ist und das Invers-Transformierungsmittel (E(z)) ein Invers-Schnelle-Fourier-Transformierungsmittel ist.

5. Verfahren zum Verarbeiten eines digitalen Signals in einem rekonfigurierbaren Digitalsignalverarbeitungssystem, mit den Schritten:
Seriell-zu-Parallel-Konvertieren eines ersten seriellen Signal (x(n)) mit einer ersten Abtastrate in eine Vielzahl (L) von parallelen Subband-Signalen mit einer zweiten Abtastrate, wobei die zweite Abtastrate geringer als oder gleich der ersten Abtastrate ist,
Verarbeiten der Subband-Signale zu verarbeiten mittels von Verarbeitungsblöcken (PB₀, PB₁, PB_{L-1}), um verarbeitete Signale zu erzeugen,
Parallel-zu-Seriell-Konvertieren der verarbeiteten Signale, um ein zweites serielles Signal (y(n)) mit einer Abtastrate, die im Wesentlichen gleich zu der ersten Abtastrate ist, aus den verarbeiteten Signalen zurückzugewinnen,
wobei bei normalem Laufzeit-Betrieb der Dezimierungsfaktor (M) eines jeden Dezimierungsblocks gleich der Anzahl (L) von Subband-Signalen ist und
wobei, wenn eine Laufzeit-Rekonfiguration nötig ist, das Verfahren die als weitere Schritte aufweist:
Verringern des Dezimierungsfaktors mittels einer Konfigurationssteuereinheit (1), so dass sich die zweite Abtastrate erhöht,
Laden der Konfiguration in den Speicher (MEM) eines Verarbeitungsblocks mittels der Konfigurationssteuereinheit,
Erhöhen des Dezimierungsfaktors mittels der Konfigurationssteuereinheit, so dass er erneut gleich der Anzahl von Subband-Signalen ist.

6. Verfahren zum Verarbeiten eines digitalen Signals in einem rekonfigurierbaren Digitalsignalverarbeitungssystem nach Anspruch 5, wobei die Konfigurationssteuereinheit (1) sukzessive Verringerungen an dem Dezimierungsfaktor (N) vornimmt, um eine Konfiguration inkrementell zu laden.

7. Verfahren zum Verarbeiten eines digitalen Signals in einem rekonfigurierbaren Digitalsignalverarbeitungssystem nach Anspruch 5 oder 6, ferner mit den Schritten:
Transformieren (R(z)) der Subband-Signale vor dem Verarbeitungsschritt, und
Invers-Transformieren (E(z)) der verarbeiteten Signale vor dem Parallel-zu-Seriell-Konvertierungsschritt.

8. Verfahren zum Verarbeiten eines digitalen Signals in einem rekonfigurierbaren Digitalsignalverarbeitungssystem nach Anspruch 7, wobei der Transformierungsschritt (R(z)) ein Schnelle-Fourier-Transformierungsschritt ist und der Invers-Transformierungsschritt (E(z)) ein Invers-Schnelle-Fourier-Transformierungsschritt ist.

## Revendications

1. Système de traitement de signal numérique reconfigurable comprenant:
un convertisseur (4) série à parallèle comprenant au moins un bloc de retard (5) et au moins un bloc de décimation (2) agencés pour convertir un premier signal série (x(n)) à un premier taux d'échantillonnage en une multiplicité (L) de signaux de sous-bandes parallèles à un deuxième taux d'échantillonnage, où le deuxième taux d'échantillonnage est inférieur ou égal au premier taux d'échantillonnage;
des blocs de traitement (PB₀, PB₁, PB_{L-1}) agencés pour traiter les signaux de sous-bandes afin de produire des signaux traités;
une unité (1) de commande de configuration agencée pour modifier le facteur de décimation (M) de chaque bloc de décimation et pour charger une configuration dans la mémoire (MEM) d'un bloc de traitement;
un convertisseur (6) parallèle à série comprenant au moins un bloc d'extension (3), le convertisseur parallèle à série agencé pour récupérer à partir des signaux traités un deuxième signal série (y(n)) à un taux d'échantillonnage essentiellement égal au premier taux d'échantillonnage;
où lors d'une opération à temps d'exécution normal, le facteur de décimation (M) de chaque bloc de décimation (2) est égal au nombre (L) de signaux de sous-bandes et lorsqu'une reconfiguration du temps d'exécution est requise, l'unité de commande de configuration est agencée pour réduire le facteur de décimation de sorte que le deuxième taux d'échantillonnage augmente; charger la configuration dans la mémoire d'un bloc de traitement; et augmenter le facteur de décimation de manière à être de nouveau égal au nombre de signaux de sous-bandes.

2. Système de traitement de signal numérique reconfigurable selon la revendication 1, dans lequel l'unité de commande (1) de configuration est agencée pour effectuer des diminutions successives dans le facteur de décimation (M) pour charger de manière incrémentielle une configuration.

3. Système de traitement de signal numérique reconfigurable selon la revendication 1 ou la revendication 2, comprenant en outre:
un moyen de transformée (R(z)) agencé pour transformer les signaux de sous-bandes avant que les signaux de sous-bandes ne soient traités par les blocs de traitement (PB₀, PB₁, PB_{L-1}); et
un moyen de transformée inverse (E(z)) agencé pour transformer à l'inverse les signaux traités avant que les signaux traités ne soient convertis de parallèle à série par le convertisseur (6) parallèle à série.

4. Système de traitement de signal numérique reconfigurable selon la revendication 3, dans lequel le moyen de transformée (R(z)) est un moyen de transformée de Fourier rapide et le moyen de transformée inverse (E(z)) est un moyen de transformée de Fourier rapide inverse.

5. Procédé de traitement d'un signal numérique dans un système de traitement numérique reconfigurable, le procédé comprenant les étapes consistant à:
réaliser une conversion série à parallèle d'un premier signal série (x(n)) à un premier taux d'échantillonnage en une multiplicité (L) de signaux de sous-bandes parallèles à un deuxième taux d'échantillonnage, au moyen d'un convertisseur (4) série à parallèle comprenant au moins un bloc de retard (5) et au moins un bloc de décimation (2), où le deuxième taux d'échantillonnage est inférieur ou égal au premier taux d'échantillonnage;
traiter les signaux de sous-bandes afin de produire des signaux traités, au moyen de blocs de traitement (PB₀, PB₁, PB_{L-1});
réaliser une conversion parallèle à série des signaux traités afin de récupérer un deuxième signal série (y(n)) à un taux d'échantillonnage essentiellement égal au premier taux d'échantillonnage à partir des signaux traités;
où lors d'une opération à temps d'exécution normal, le facteur de décimation (M) de chaque bloc de décimation est égal au nombre (L) des signaux de sous-bandes et lorsque la reconfiguration du temps d'exécution est requise, le procédé comprend en outre les étapes consistant à:
réduire le facteur de décimation du bloc de décimation de sorte que le deuxième taux d'échantillonnage augmente, au moyen d'une unité (1) de commande de configuration;
charger une configuration dans la mémoire (MEM) d'un bloc de traitement au moyen de l'unité de commande de configuration;
augmenter le facteur de décimation de manière à être de nouveau égal au nombre de signaux de sous-bandes, au moyen de l'unité de commande de configuration.

6. Procédé de traitement d'un signal numérique dans un système de traitement numérique reconfigurable selon la revendication 5, dans lequel l'unité (1) de commande de configuration effectue des étapes successives de réduction du facteur de décimation et charge de manière incrémentielle une configuration.

7. Procédé de traitement d'un signal numérique dans un système de traitement numérique reconfigurable selon la revendication 5 ou la revendication 6, comprenant en outre les étapes consistant à:
transformer (R(z)) les signaux de sous-bandes avant l'étape de traitement; et
transformer à l'inverse (E(z)) les signaux traités avant l'étape de conversion parallèle à série.

8. Procédé de traitement d'un signal numérique dans un système de traitement de signal numérique selon la revendication 7, dans lequel l'étape de transformée (R(z)) est une étape de transformée de Fourier rapide et l'étape de transformée inverse (E(z)) est une étape de transformée de Fourier rapide inverse.
